Europäisches Patentamt

European Patent Office

Office européen des brevets

(11) Publication number: **0 428 838 A1**

# EUROPEAN PATENT APPLICATION

(21) Application number: 90116557.1

(22) Date of filing: 29.08.90

(51) Int. Cl.⁵: **H05K 13/00**

(30) Priority: 20.11.89 US 439713

(43) Date of publication of application:
29.05.91 Bulletin 91/22

(84) Designated Contracting States:
DE FR GB

(71) Applicant: **Hewlett-Packard Company**
Mail Stop 20 B-O, 3000 Hanover Street
Palo Alto, California 94304(US)

(72) Inventor: **Leibovitz, Jacques**
1536 Larkspur Drive
San Jose, CA 95125(US)
Inventor: **Scholz, Kenneth Donald**
4150 Willmar Drive
Palo Alto CA 94306(US)
Inventor: **Cobarruviaz, Maria Lucia**
10825 Stevens Canyon Road
Cupertino CA 95014(US)
Inventor: **Chao, Clinton Chih-Chieh**
51 Waterside Circle
Redwood City CA 94065(US)

(74) Representative: **Liesegang, Roland, Dr.-Ing. et al**
**FORRESTER & BOEHMERT**
Widenmayerstrasse 4 Postfach 22 01 37
W-8000 München 22(DE)

(54) **A method and apparatus for reel to reel manufacturing of high performance multilayer circuit interconnect units.**

(57) The present invention discloses a method of producing multilayer interconnect units with a continuous process product manufacturing system. A novel tape transport system (103) comprising a tape (104) is used which provides a dimensionally stable substrate for fabrication of multilayer circuit interconnect units at workstations (102) arranged adjacent the transport path of said tape (104). This tape transport system (103) also provides for improved yields and lower manufacturing costs.

FIG. 1

# A METHOD AND APPARATUS FOR REEL TO REEL MANUFACTURING OF HIGH PERFORMANCE MULTILAYER CIRCUIT INTERCONNECT UNITS

## BACKGROUND OF THE INVENTION

### 1. Field of the Invention

The present invention relates generally to continuous manufacturing processes and devices related thereto. More particularly the present invention is related to methods and devices for the manufacture of high performance multilayer interconnect units.

### 2. Related Art

Various types of high performance multi-chip modules are used in high end computing machines where cost is of secondary importance. Indeed, the highest performance multi-chip modules contain multilayer copper circuit interconnects with polyimide dielectric on rigid substrates and are the most expensive.

In a conventional process, the multilayer circuit interconnect is built layer by layer, upon a rigid substrate, through the processes of deposition and selective etching using standard photolithographic techniques. The rigid substrate was found to be necessary to assure geometrical and dimensional stability during processing.

The conventional approach to building multilayer circuit interconnect units is to use a batch process wherein each operation takes place at a particular workstation. The layers are sequentially built on individual substrates, in batches, each layer requiring several costly steps such as sputtering and reactive ion etching (RIE). The multilayer circuit interconnect is moved from one workstation to another by one or more operators. A workstation may be a piece of equipment such as a sputter deposition system, a reactive ion etcher, a photo mask aligner, an oven or any other type of processing, measuring or inspecting apparatus used in the multilayer circuit interconnect fabrication process and the ancillary constructions necessary for operator convenience, safety and efficiency.

The batch processing is labor intensive and slow. The use of human operators is expensive in several ways. First, there are the direct labor costs. Secondly, there are costs which result from human errors. Human operators also act to increase production costs by reducing yield simply because particulate contamination is greater in the clean room environment when humans are present. The negative effects of particulate contamination on yield are well known. If human operators are present, the known particulate contamination problems are conventionally overcome by expensive air flow and filtration systems as well as providing special clothing for the operators.

In this discussion production costs, processing costs and manufacturing costs are used interchangeably.

## FEATURES OF THE INVENTION

It is a feature of the present invention to reduce processing costs by reducing the amount of labor involved in multilayer circuit interconnect production. The invention is designed to improve yield by reducing operator introduced particulate contamination.

Reduction of human operator intervention in the multilayer circuit interconnect fabrication process is achieved with the present invention by interconnecting workstations with a transport system. In order to meet its objectives, the transport system of the present invention has the following features:

1) it allows the multilayer circuit interconnect units to be built onto a transport system;

2) it allows the multilayer circuit interconnect units to be removed from a transport system;

3) it provides a dimensionally stable processing surface;

4) it provides for the incorporation of transport tape "slack";

5) it is physically able to withstand the conditions within the various workstations of the process without affecting dimensional stability to the extent that desired process geometries cannot be achieved;

6) it allows the use of feed reels and pickup reels, where the transport tape with the multilayer circuit interconnect units in various stages of fabrication may be wound up on the pickup reel without damage; and

7) it allows for the use of protective tape feed reels in conjunction with the pickup reels.

## SUMMARY OF THE INVENTION

The present invention is a type of multilayer circuit interconnect product manufacturing system and method which overcomes the problems found in conventional multilayer circuit interconnect manufacturing.

The present invention is a device and method wherein a batch process of manufacturing may be converted to a continuous process. The invention achieves this result by adapting and then interconnecting workstations with a transport system. This transport system is characterized in that it uses a tape flexible enough to be wound on reels while being dimensionally stable in the orientation of its surface. The transport system is further characterized in that the tape is not detrimentally affected by heating, etching or other process steps as might be found in a multilayer circuit interconnect process environment.

The dimensional stability of the tape throughout the process allows the tape to be used as a substrate for the fabrication of multilayer circuit interconnect units. It is preferable to reuse the transport tape. The present invention achieves this reusability of the transport tape by means of a temporary adhesion layer. The temporary adhesion layer provides for the multilayer circuit interconnect units to be removably attached to the substrate transport tape.

## BRIEF DESCRIPTION OF THE DRAWINGS

The foregoing and other objects, features and advantages of the present invention should become apparent from the following description when taken in conjunction with the accompanying drawings, in which:

FIG. 1 shows workstations interconnected by the transport system, a transport tape feed reel, a transport tape pickup reel and a protective tape feed reel.

FIG. 2 shows a view of the transport system including multilayer circuit interconnect units removably attached to the transport tape, and the spring loaded rollers which are used for controlling the localized effective speed of the transport tape.

FIG. 3 is a sectional view of the transport system wherein the spring loaded rollers are in the extended position.

FIG. 4 is a sectional view of the transport system showing the spring loaded rollers in the contracted position.

FIG. 5 shows the stainless steel and polyimide transport tape of the preferred embodiment in a reel cross-section.

FIG. 6 shows a cross-section of the multilayer circuit interconnect after via etch but before resist strip.

FIG. 7 shows a cross-section of the multilayer circuit interconnect after polyimide deposition over the ground plane vias.

FIG. 8 shows a cross-section of the multilayer circuit interconnect after removing the polyimide layers from the vias top.

FIG. 9 shows a cross-section of the multilayer circuit interconnect indicating fabrication of the first metal layer.

FIG. 10 shows a cross-section of the multilayer circuit interconnect during a photomasking step.

FIG. 11 shows a cross-section of the multilayer circuit interconnect, depicting the dielectric layers over the vias top.

FIG. 12 shows a cross-section of the multilayer circuit interconnect after the last step in the fabrication of a metal layer.

FIG. 13 shows the nested mask alignment marks employed by the automatic alignment feature of the present invention.

## DETAILED DESCRIPTION OF THE PREFERRED EMBODIMENT

The present invention is a multilayer circuit interconnect product manufacturing system and method wherein labor costs and human errors are reduced, and yield is increased.

In this description of the preferred embodiment the term "frontside" means that side of the transport tape upon which the multilayer circuit interconnect is built. The term "backside" refers to that side of the transport tape which is coated with polyimide to protect it from physical and chemical attack by the various process steps, and upon which products are not built.

The continuous reel to reel manufacturing method of this invention provides a greater degree of automation, less labor and faster processing than conventional methods. Taken together, this means higher capacity per unit of invested capital and therefore greatly reduced manufacturing costs.

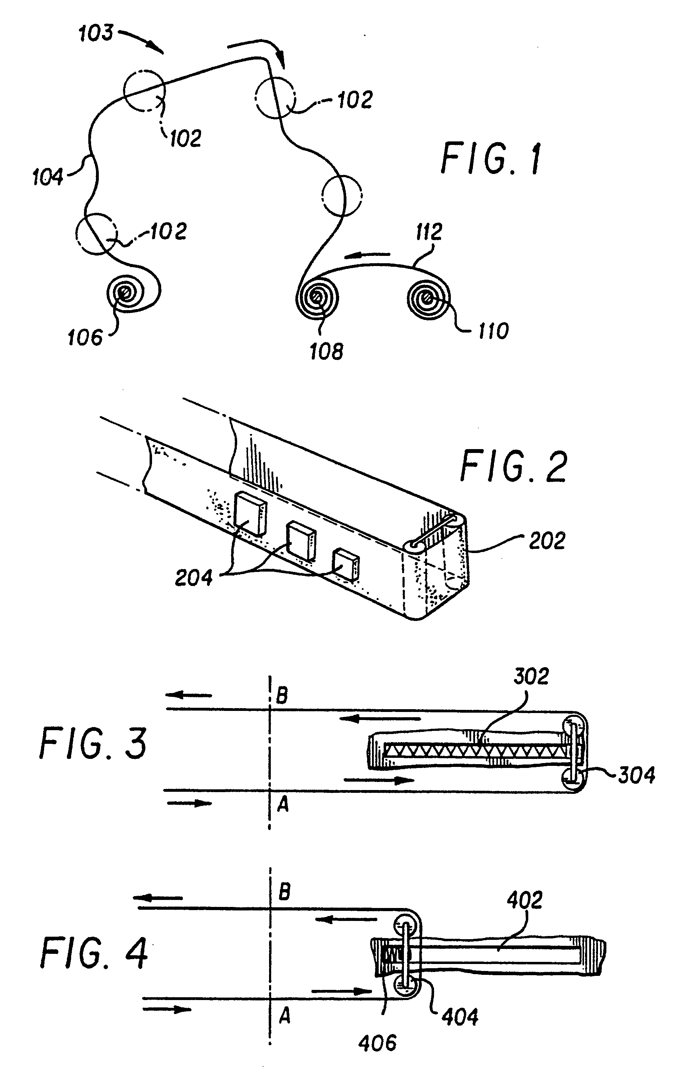

## A. Manufacturing Apparatus (Figs. 1 - 4)

The manufacturing apparatus of the preferred embodiment is used to achieve a substantially continuous process of manufacturing. A diagram representation of the manufacturing apparatus is pictured at Figure 1. This manufacturing apparatus comprises a plurality of workstations **102** for fabricating multilayer circuit interconnect units, and a reel to reel transport system **103** operatively joining workstations **102**. The reel to reel transport system **103** comprises a transport tape **104**, transport tape feed reels **106**, transport tape pickup reels **108**, protective tape feed reels **110**, spring loaded rollers **202** for taking up tape slack caused by localized tape speed changes, and a controlled path **302** for each spring loaded roller.

The transport tape **104** is passed through one or more workstations **102** where the various processing steps take place. At the end of a series of workstations the tape **104** is wound onto a pickup reel **108** along with a protective tape **112** that comes from a protective tape feed reel **110**. The purpose of the protective tape is to prevent damage to the partially completed multilayer interconnect unit. The protective tape of the preferred embodiment is a lintless, non-acid paper.

Figure 2 shows multilayer circuit interconnect units **204** at various stages of a manufacturing without showing the intervening workstations. Units **204** are not drawn to scale, and in a preferred embodiment the multilayer circuit interconnect comprises a single continuous unit.

The manufacturing apparatus and method of this invention can be computer-controlled; however, the complexity of the computer system can vary greatly. The system need not be "computer" controlled, but can be controlled by other conventional, less sophisticated means.

The function of the spring loaded rollers **202** can best be understood by reference to Figs. 3 and 4. It can be seen that the length of tape between points A and B in Fig. 3, where the rollers are extended, is greater than the length of tape between the equivalent points A and B in Fig. 4, where the rollers are contracted. The average tape speed is constant. However, the tape speed changes locally at various workstations **102** because of different predetermined process time requirements. Referring to Figure 4, when the tape is moving faster at point A than at point B, the length of tape between points A and B increases and the spring loaded rollers extend as shown in Figure 3 to take up the slack. Conversely, when the tape is slower at point A than it is at point B, the spring means **406** of the spring loaded rollers **404** compresses within control path **402**, thus shortening the length of tape between points A and B to compensate for the tape speed fluctuation. Hence, the spring loaded rollers accommodate tape speed fluctuations as a result of localized tape speed changes designed into the system to meet the different time requirements of various workstations.

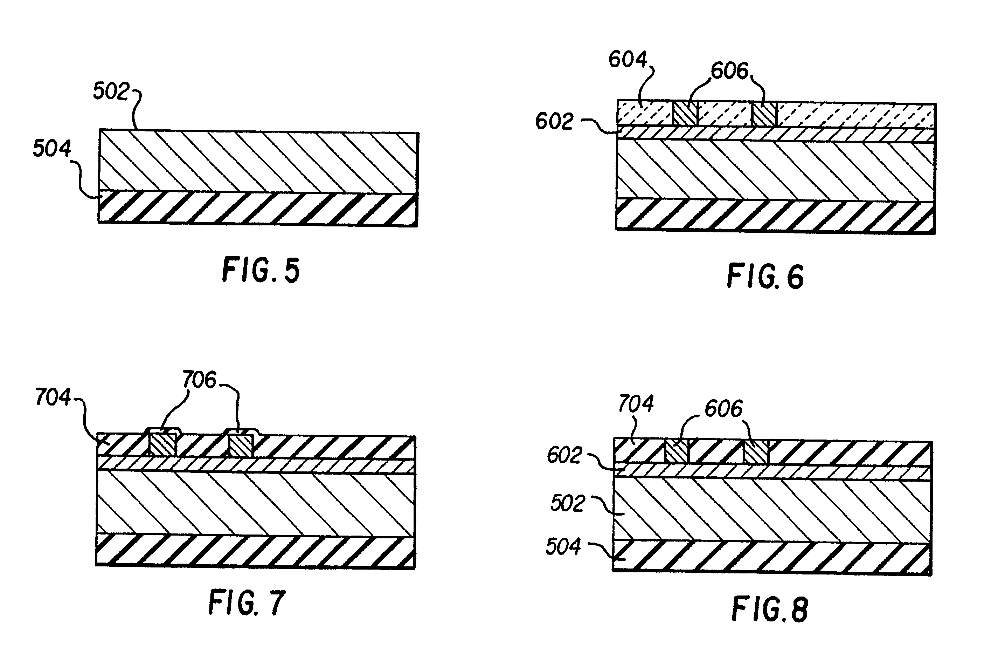

## B. Manufacturing Method (Figs. 5 - 13)

The manufacturing method of the preferred embodiment is used to produce multilayer circuit interconnect units.

Manufacturing is started with a stainless steel tape **502**, to serve as a support. Stainless steel is employed because it is dimensionally stable in the two coordinate directions orthogonal to its thickness (i.e., length and width). The flexibility of the tape in the direction of its thickness allows it to be reeled and trained around rollers. Stainless steel tape **502** has a polyimide layer **504** on one side (that side being known as the backside). Polyimide is a dielectric used in the preferred embodiment; however, other suitable organic dielectric materials may be employed. The tape is initially wound onto a reel known as the feed reel. The tape is threaded through one or more workstations **102** around one or more spring loaded rollers **202** and onto a pickup reel **106**.

The first processing/fabrication step is to sputter deposit, onto the frontside, a composite metal layer **602** of approximately 1 micron of solder, approximately 0.05 micron of chromium, approximately 5.0 microns of copper and approximately 0.05 micron of chromium. The solder layer is a temporary adhesion layer.

The composition of the solder is selected in conjunction with other process steps. For example, a Lead - Tin solder is selected in one preferred embodiment where prepared polyimide films are applied by lamination with an adhesive. Higher melting point solders are used in another preferred embodiment where polyimide is applied in the liquid state and subsequently dried and cured.

The via mask photo step is next. This consists of the well known techniques of photoresist application, softbake, alignment, exposure, development and hardbake. This process takes place on the frontside of the tape. The exposed chromium is etched and the vias plated-up with copper **606**. The photoresist is then stripped.

Photosensitive polyimide **704** is then applied to the frontside. At this point there are polyimide bulges **706** on top of the vias.

Polyimide bulges **706** are later removed by known alignment techniques, followed by exposure through a suitable mask and subsequent development, thus clearing the top of the copper vias as shown in Fig. 8.

Use of a photosensitive polyimide **704** may be replaced with conventional polyimide by employing an additional via mask photo step followed by removal of the exposed polyimide by reactive ion etching.

The process steps for the first metal layer, labelled S.1 through S.12, are as follows:

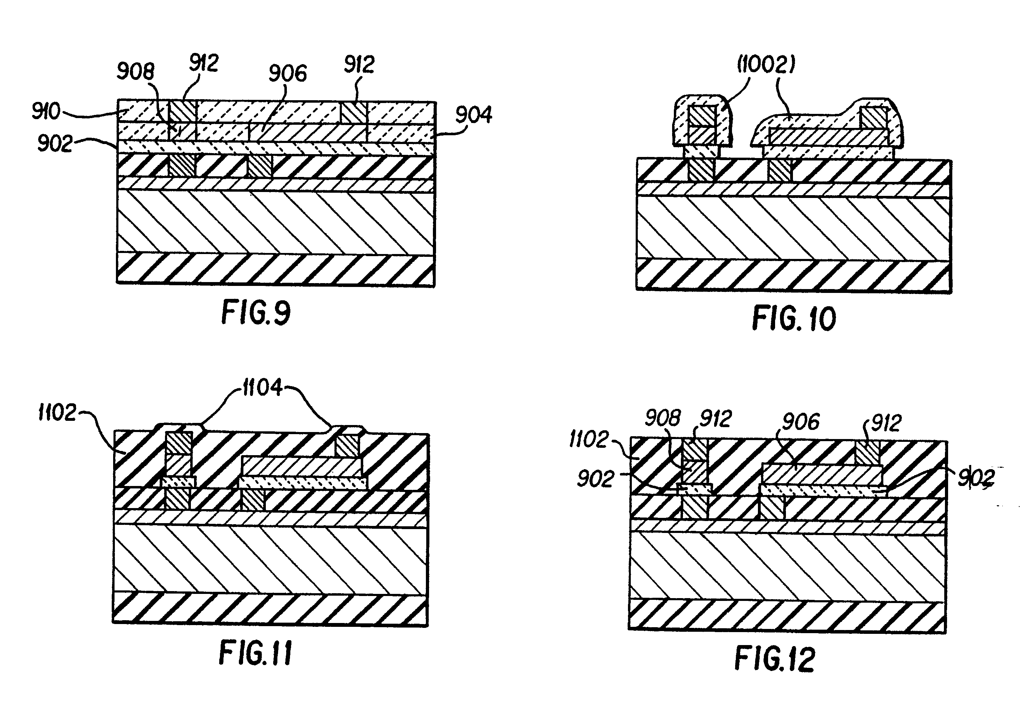

S.1 At Figure 9, a temporary connecting base **902** is formed by sputter depositing Cr, 0.05 micron/Cu, 1.0 micron/Cr, 0.05 micron, on the front side only.

S.2 Photoresist mask **904** (metal pattern) is then applied to the front side.

S.3 The exposed Cr is etched and copper metal **906** including vias **908** is plated-up.

S.4 Additional photoresist mask **910** (vias pattern) is applied to the front side.

S.5 Cu vias **912** is then plated-up, as shown in Figure 9.

S.6 The photoresist is then stripped away.

S.7 A 0.05 micron Cr layer is sputter-deposited on the front side.

S.8 Photoresist mask **1002** is applied to the front side (mask lines and vias).

S.9 The exposed Cr/Cu/Cr connecting base is stripped as shown in Figure 10.

S.10 The photoresist is then stripped.

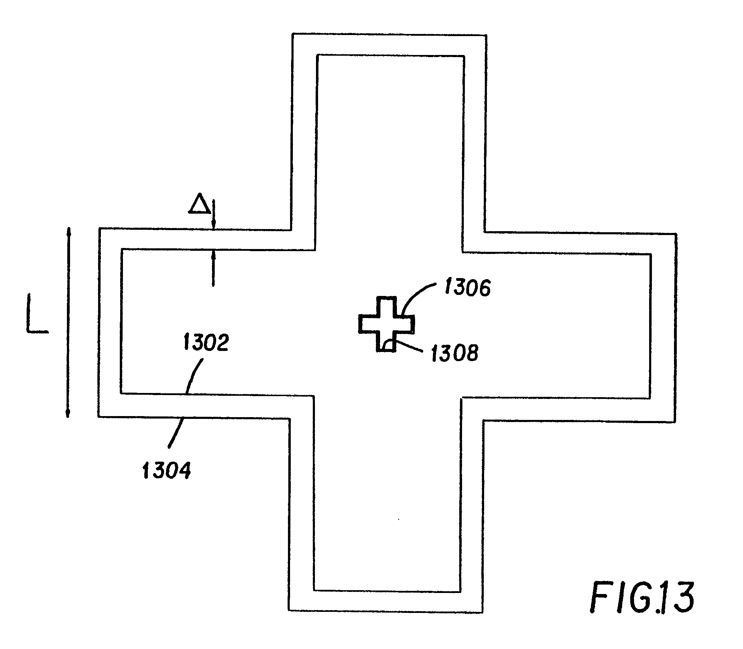

S.11 As shown in Figure 11, photosensitive polyimide layer **1102** is applied to the front side, forming bulges **1104** on top of the vias.

S.12 The photosensitive polyimide layer is aligned and exposed through a suitable mask, and subsequently developed to clear the polyimide from the Cu vias top, as shown in Figure 12.

Additional metal interconnect layers are added by repeating steps S.1 through S.12.

The pad layer is formed by patterning a composite metal film. This film is created by sputter depositing approximately 0.05 micron of chromium, approximately 0.25 micron of nickel - vanadium, and approximately 0.05 micron of gold. The patterning is achieved by a pad mask photo step. After the photoresist is defined, the Cr/Ni-V/Au composite metal film is etched to form the pads (not pictured). The photoresist is then stripped.

Once the continuous tape process is complete, the multilayer circuit interconnect unit is removed from the stainless steel transport tape to complete the manufacturing process. This removal is preferably achieved by heating the stainless steel transport tape to melt the solder which has acted as an adhesion layer for the duration of the manufacturing process.

Typically, the processed area spans the entire length of the transport tape; however, individual multilayer interconnect units may be spatially separated on the tape by plain, unpatterned areas of metal and/or a polyimide.

Automatic mask alignment is used in the method of the preferred embodiment. Several sets of automatic alignment marks are used for each multilayer circuit interconnect unit as shown in Figure 13. These alignment marks are graded from coarse to fine. The coarse marks labeled **1302** and **1304** are large and the fine marks **1306** and **1308** are small. The marks should be nested so that the innermost are the smallest and finest, while the outermost marks are the largest and coarsest. It may be possible to use manual alignment techniques but automatic alignment yields lower cost.

In a preferred embodiment of the present invention, two sets of nested alignment marks are located at opposite corners of the alignment area (not pictured). Each set includes three (3) pairs of nested marks; however, only two (2) sets are shown at Figure 13. Each pair is formed of an outer and an inner line. The separation between the two lines of each pair is approximately 4% of the width of the cross branch.

One of the crosses of each pair is located on the substrate **1304** for example, and the other, **1302**, on the mask. The mask is aligned when the inner cross of the innermost pair (not shown) fits inside the corresponding outer cross. Of course, this alignment is done for each set of nested marks on the opposite corners of the alignment area.

The coarser marks are used to locate the approximate location of the alignment marks and the inner two pairs of marks are used for final alignment after magnification of the alignment field area.

As a dimensional example of these nested alignment marks, the following table lists the approximate size of the associated alignment marks shown in Figure 13.

| Marks | Size |
|---|---|
| Intermediate marks: | |
| L<br>delta | 350μm<br>50μm |
| Innermost marks:<br>(dimensions not<br>shown) | |
| L$'$<br>delta$'$ | 35μm<br>5μm |
| Outermost marks:<br>(not shown) | |
| L1<br>delta1 | .35cm<br>.05cm |
| ALIGNMENT MARK TABLE | |

Some of the above described processing steps may be well known. However, the advantage of the present invention comes from solving the problem of integrating the process steps with a novel transport system to produce a continuous process of multilayer circuit interconnect manufacturing.

While preferred embodiments have been set forth, various modifications, alterations, and changes may be made without departing from the spirit and scope of the present invention as defined in the appended claims.

## Claims

1. A method of producing multilayer circuit interconnect units, **characterized** by the steps of
providing a protective layer (504) on a backside of a transport tape (502);
passing said transport tape through at least one work station (102);
creating a temporary adhesion layer (602) on said transport tape (502);
performing process operations on frontside portions of the transport tape (502) which are coated with said temporary adhesion layer (602) to build up said multilayer circuit interconnect units; and
removing said multilayer circuit interconnect units from said transport tape.

2. A method as claimed in claim 1, further comprising the step of:
forming said temporary adhesion layer (602) from a solder composition, preferably from Lead-Tin solder.

3. A method as claimed in claim 1 or 2, further comprising the step of:
forming said layer (602) to a thickness of approximately 1 micron.

4. A method as claimed in one of the preceding claims, wherein removing said multilayer circuit interconnect units comprises the steps of:
heating the transport tape (502);
melting the temporary adhesion layer (602); and
freeing said multilayer circuit interconnect unit from said transport tape.

5. A method as claimed in one of the preceding claims, **characterized** in that said protective layer (504) is formed of polyimide.

6. A method as claimed in one of the preceding claims, **characterized** in that said temporary adhesion layer (602) is created by
sputter depositing a layer of solder approximately 1.0 micron thick; and
sputter depositing a layer of chromium approximately 0.05 microns thick.

7. A method as claimed in one of the preceding claims, **characterized** in that
said process operations form a plurality of multilayer circuit interconnect subunits spatially separated on the front side portions of the tape by plain, unpatterned areas of metal and/or a polyimide.

8. A continuous process manufacturing system, particularly for use in a continuous path multilayer circuit interconnect manufacturing process, **characterized** by
a plurality of workstations (102);

a workpiece substrate (104) upon which a product is built;

a transport system (103) operatively associated with the workstations (102) and operable such that said workpiece substrate is moved from one workstation to another workstation along a continuous path in a predetermined order; and

a final workstation wherein said product is removed from said transport system.

9. A product manufacturing system as claimed in claim 8, **characterized** in that the transport system (103) comprises a transport tape (104), which is dimen sionally stable in the two directions orthogonal to the thickness of the tape, transport tape feed reels (106) and transport tape pickup reels (108).

10. A product manufacturing system as claimed in claim 9, **characterized** by at least one protective tape feed reel (110).

11. A product manufacturing system as claimed in one of claims 8 to 10, **characterized** by

at least one set of rollers (202) around which said transport tape (104) is trained; and

control means, particularly spring means (302) coupled with said rollers (202) for adjusting the position of said rollers to accommodate path length changes of said transport tape (104) relative to said workstations (102).

12. A product manufacturing system as claimed in claim 9, **characterized** in that the transport tape (104) comprises a stainless steel tape (502) and a polyimide layer (504) attached to the backside of the tape.

13. A product manufacturing system as claimed in claim 10, **characterized** in that the protective tape comprises a lintless, non-acid paper.

14. A product manufacturing system as in one of claims 9 to 13, **characterized** in that

a temporary adhesion layer (602) is disposed on the front surface of said tape (104).

FIG. 1

FIG. 2

FIG. 3

FIG. 4

502

504

**FIG. 5**

EP 0 428 838 A1

604 606

602

**FIG. 6**

704 706

**FIG. 7**

704 606

602

502

504

**FIG. 8**

EP 0 428 838 A1

FIG.10

FIG.12

FIG.9

FIG.11

10

FIG13

## DOCUMENTS CONSIDERED TO BE RELEVANT

EP 90116557.1

| Category | Citation of document with indication, where appropriate, of relevant passages | Relevant to claim | CLASSIFICATION OF THE APPLICATION (Int. Cl. 5) |
|---|---|---|---|
| A | DE - A1 - 3 438 123 (SACHSZE) * Abstract; fig. 1-7 * | 1,8 | H 05 K 13/00 |
| A | JP - A - 58-61 272 (AGENCY OF IND. SCI, TECH.) * Abstract; fig. 1 * | 1,8 | |
| A | DE - A1 - 3 117 239 (PLESSEY) * Abstract; fig. 1 * | 1,8 | |
| | | | TECHNICAL FIELDS SEARCHED (Int. Cl.5) |
| | | | H 05 K 13/00 |

The present search report has been drawn up for all claims

| Place of search | Date of completion of the search | Examiner |
|---|---|---|
| VIENNA | 12-02-1991 | VAKIL |

EPO FORM 1503 03.82 (P0401)